## Europäisches Patentamt
## European Patent Office
## Office européen des brevets

(11) Veröffentlichungsnummer : **0 280 089 B1**

# EUROPÄISCHE PATENTSCHRIFT

(45) Veröffentlichungstag der Patentschrift :
**03.04.91 Patentblatt 91/14**

(51) Int. Cl.$^5$ : **H01L 21/285, C23C 14/00**

(21) Anmeldenummer : **88101643.0**

(22) Anmeldetag : **04.02.88**

(54) **Verfahren zum Herstellen einer als Kontakt- und Barriereschicht wirkenden Titan/Titannitrid-Doppelschicht in höchstintegrierten Schaltungen.**

(30) Priorität : **10.02.87 DE 3704055**

(43) Veröffentlichungstag der Anmeldung :
**31.08.88 Patentblatt 88/35**

(45) Bekanntmachung des Hinweises auf die Patenterteilung :
**03.04.91 Patentblatt 91/14**

(84) Benannte Vertragsstaaten :
**AT CH DE FR GB IT LI NL**

(56) Entgegenhaltungen :
**EP-A- 0 043 781**
**GB-A- 2 130 795**
**GB-A- 2 166 162**
**GB-A- 2 170 226**

(73) Patentinhaber : **Siemens Aktiengesellschaft**
**Wittelsbacherplatz 2**
**W-8000 München 2 (DE)**

(72) Erfinder : **Kohlhase, Armin, Dr.**
**Unterhachinger Strasse 85d**
**W-8000 München 83 (DE)**
Erfinder : **Higelin, Gerald, Dr.**
**Fasangartenstrasse 164**
**W-8000 München 82 (DE)**

## Beschreibung

Die Erfindung betrifft ein Verfahren zum Herstellen von als Kontakt- und Barriereschicht wirkenden, aus Titan/Titannitrid bestehenden Doppelschichten, wie sie zwischen Metallisierungen auf Aluminiumbasis und Silizium- und/oder Silizid/Polyzid-Oberflächen in höchstintegrierten Halbleiterschaltungen verwendet werden, durch Kathodenzerstäuben (Sputtern) aus einem Titantarget unter Zuschalten von Stickstoff in einer Einkammer-Anlage mit statischem Magnetron.

Als Folge der Löslichkeit von Silizium in Aluminium tritt bei der Herstellung von hochintegrierten Halbleiterschaltungen ohne geeignete Gegenmaßnahmen an den Kontakten zu dotierten Siliziumbereichen (Diffusionsgebiete im Substrat) oder Polysilizium das sogenannte "Spiking" auf, das heißt, Aluminium-"Nadeln" dringen ins Silizium ein, was zu Kurzschlüssen führen kann, insbesondere bei immer kleiner werdenden Strukturen und gleichzeitig flacher werdenden Diffusionsgebieten.

Zunächst konnte dieses Problem durch geringe Zugaben von Silizium zum verwendeten Aluminium behoben werden. Dieses Silizium kann sich jedoch an den Aluminium/Silizium-Kontaktflächen ausscheiden und dort wiederum zu Schwierigkeiten mit den Übergangswiderständen führen.

Eine Möglichkeit, die eigentliche Ursache, nämlich die Diffusion zwischen dem dotierten Siliziumsubstrat oder Polysilizium und der Aluminium-Metallisierung zu verlangsamen, ist die Schaffung einer (Diffusions-) Barriereschicht. Als Materialien kommen die Nitride, Karbide und Boride der Metalle der Untergruppen IVB, VB und VIB des Periodensystems infrage. Speziell der Einsatz von Titannitric als Diffusionsbarriere ist eingehend in einem Aufsatz von Kanamori im "Thin Solid Films" 136 (1986) auf den Seiten 195 bis 214 untersucht worden. Es zeigt sich, daß die Barriereeigenschaften dabei stark vom Herstellungsverfahren, von der verwendeten Anlage und von den eingestellten Prozeßparametern abhängen. Ein häufig angewandtes Verfahren ist Reaktivsputtern in einer stickstoffhaltigen Sputteratmosphäre. Hierbei ändern sich mit zunehmendem Stickstoffanteil im Sputtergas bei konstant gehaltener Sputterleistung und konstantem Gesamtsputterdruck einige Eigenschaften der erzeugten Titannitridschichten drastisch : einhergehend mit Veränderungen in der Morphologie der Schichten wechselt die Farbe von silber über silbergold, gold, goldbraun und braunviolettmetallisch nach braun-metallisch. Ab einer bestimmten Stickstoffkonzentration in der Sputteratmosphäre nimmt die Sputterrate sprunghaft auf ein Drittel ab, während die Leitfähigkeit der erzeugten Titannitridschichten um ca. einen Faktor 3 steigt. Der Punkt, an dem dies passiert, hängt ferner vom Gesamtsputterdruck und von der Sputterleistung ab und ist gekennzeichnet durch die goldene Farbe sowie ein Verhältnis von Stickstoff (N) zu Titan (Ti) in der Schicht von 1 : 1. Außerdem zeichnet sich dieser Bereich der "goldenen Stöchiometrie" durch eine hohe Dichtigkeit gegen Diffusion durch die Titannitridschicht aus, was zunächst auf gute Barriereeigenschaften schließen läßt. Aber auch die mechanischen Spannungen (Streß), die durch die Schicht entstehen, haben hier ein Maximum. Dies kann Mikrorisse mit anschließendem Durchbruch der Barriere zur Folge haben.

Als Lösung wird, wie aus einem Bericht von I. Iwabuchi et. al. aus dem Tagungsband des 1986 Symposium on VLSI-Technology in San Diego, Seiten 55/56, hervorgeht, das Auffüllen dieser Risse mit Sauerstoff vorgeschlagen. Dadurch wird aber der Gesamtprozeß durch einen zusätzlichen Nachbehandlungsschritt komplizierter. Obwohl die Barriereschichten in der Regel nur ca. 100 nm dick sind, erscheint außerdem das Arbeiten in dem Bereich mit unstabilem spezifischen Widerstand aus Gründen der Prozeßsicherheit als unvorteilhaft.

Die Aufgabe, die der Erfindung zugrundeliegt, besteht in der Herstellung einer Kontakt- und Barriereschicht aus Titannitrid zwischen einer Aluminium-Metallisierung und Siliziumkristalloder Silizid- und Polyzid-Oberflächen, die folgende Anforderungen erfüllt :

1. Es soll eine hohe Leitfähigkeit vorhanden sein.

2. Es sollen kleine Kontaktwiderstände mit geringen Toleranzen bei Kontaktlochdurchmessern im subµm-Bereich bei der Kontaktierung von dotiertem einkristallinem und polykristallinem Silizium und Schichten aus Metallsiliziden und Polysilizium erzielt werden.

3. Die Grenzflächen zwischen der vorzugsweise aus einer Aluminium/Silizium-Legierung bestehenden Metallisierung und den unter 2. genannten Siliziumbereichen müssen bei hohen Stromdichten und erhöhter Temperatur stabil sein.

4. Die Kontakt- und Barriereschicht darf keine negativen Einflüsse auf den Gesamtprozeß haben, zum Beispiel dürfen durch die Schicht keine mechanischen Spannungen (Streß) erzeugt werden.

Eine hohe Leitfähigkeit wird durch die Verwendung einer Aluminium (1% Silizium)-Metallisierung gewährleistet.

Geringe Kontaktwiderstände werden erhalten durch die Ausbildung einer Titansilizid-Kontaktschicht, wenn vor der Titannitridschicht eine reine Titanschicht abgeschieden wird.

Die Stabilität bei erhöhter Temperatur und Strombelastung bei gleichzeitig minimalem Streß ist aber nur durch das erfindungsgemäße Verfahren zu erreichen, welches dadurch gekennzeichnet ist, daß sowohl die Titanschicht, als auch die Titannitridschicht in mehreren Einzellagen abgeschieden wird, wobei zwischen den eizelnen Abscheidungshritten eine Temperaturbehandlung durchgeführt wird und bei der Abscheidung der Titannitridschicht der Stickstofanteil im Reaktionsgas höher eingestellt wird, als es der Stöchiometrie der Verbindung Titan : Stickstoff in der Titannitridschicht entspricht.

Dabei liegt es im Rahmen der Erfindung, daß die Schichtdicke der Einzellagen im Bereich von 3 bis 5 nm, vorzugsweise auf 4 nm eingestellt wird und die Temperaturbehandlung im Bereich von 250 bis 350°C, vorzugsweise bei 300°C durchgeführt wird.

In einer Weiterbildung des Erfindungsgedankens ist vorgesehen, für die Schichtherstellung eine DC (= direct current)-Einkammer-Sputteranlage zu verwenden, bei der die für die Beschichtung vorgesehenen Substrate auf einer, in der Horizontalen drehbaren Palette ortsfest angeordnet sind, die Palette während der Beschichtung in Umdrehungen versetzt wird und die Drehgeschwindigkeit so eingestellt wird, daß eine Umdrehung der Abscheidung einer Einzellage entspricht.

Durch den Aufbau des Titannitrids aus mehreren Einzellagen und abwechselndem Sputtern und Heizen, bedingt durch das Drehen der Palette, wobei die Substrate unter dem Target und unter den Heizquellen durchgefahren werden, gelingt es, nahezu streßfreie Schichten zu erzeugen (Scheibenverbiegung von Siliziumkristallwafern mit 100 mm Durchmesser ist kleiner gleich 1 μm), die sich durch gute thermische Stabilität (500°C, 30 Minuten) und Strom/Streßbelastung in 1,1 μm-Kontakten (größer 1200 Stunden), sowie geringe Kontaktwiderstände und Diodenleckströme auszeichnen. Die Prozeßparameter werden so gewählt, daß eine hohe Prozeßsicherheit (Stickstofffluß oberhalb der "goldenen Stöchiometrie") mit akzeptablem Durchsatz (Sputterleistung ca. 3 KW) gewährleistet ist.

Weitere Ausgestaltungen der Erfindung ergeben sich aus den Unteransprüchen.

Im folgenden wird anhand eines Ausführungsbeispiels und der Figuren 1 bis 3 die Erfindung noch näher erläutert. Dabei zeigen

die Figuren 1 und 2 im Schnittbild einen Schichtaufbau, wie er nach dem erfindungsgemäßen Verfahren hergestellt worden ist, wobei die Figur 2 einen Ausschnitt aus Figur 1 darstellt und

die Figur 3 in Draufsicht die für die Beschichtung vorgesehene Palette mit Sputtertarget und Heizer.

In allen Figuren gelten für gleiche Teile gleiche Bezugszeichen.

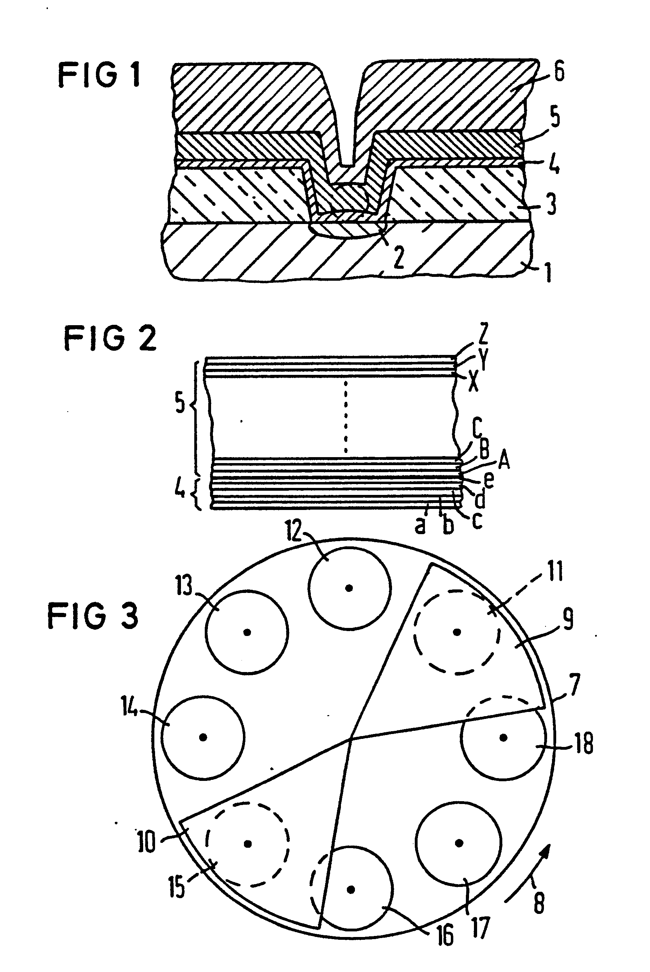

Figur 1 : Mit dem Bezugszeichen 1 ist das den n+- bzw. p+-dotierten flachen Bereich 2 enthaltende Siliziumsubstrat und mit 3 die das Kontaktloch enthaltende isolierende, zum Beispiel aus SiO₂ bestehende Schicht bezeichnet. Das Kontaktloch hat einen Querschnitt von 0,9 μm und eine Tiefe von 1 μm. Mit Hilfe

des erfindungsgemäßen Sputterverfahrens wird nun auf die kurz vorher durch kurzes Überätzen in Flußsäure (120 Sekunden) von Oberflächenoxid befreite Substratscheibe (1, 2, 3) ganzflächig im Argonplasma lagenweise (zum Beispiel fünf Lagen) eine Titanschicht 4 in einer Schichtdicke von 20 nm aufgebracht und darauf ohne Unterbrechung des Vakuums durch Zuschalten von Stickstoff eine zum Beispiel aus 25 Lagen bestehende Titannitridschicht 5 mit einer Schichtdicke von 100 nm abgeschieden.

Der Basisdruck in der Sputteranlage beträgt vor dem Sputtern $7 \times 10^{-5}$ pa. Der Rezipient wird für den Abscheidevorgang durch Infrarotstrahler (siehe Figur 3) auf eine Temperatur von 300°C gebracht. Bei der Titannitridabscheidung (5) wird der Gasfluß von vorher 47 cm³/min (sccm) Argon auf 21 cm³/min (sccm) Argon und 32 cm³/min (sccm) Stickstoff eingestellt. Die Leistung des Titantargets (siehe Figur 3) beträgt 3,07 kw.

Auf die aus Titan/Titannitrid bestehende, in Einzellagen (siehe Figur 2) abgeschiedene Doppelschicht 4, 5 mit einer Gesamtschichtdicke von ca. 120 nm wird dann die aus zum Beispiel Aluminium/Silizium oder einer Aluminium/Silizium/Kupfer-Legierung bestehende Metallisierungsebene 6 in bekannter Weise aufgebracht.

Figur 2 zeigt einen Ausschnitt aus Figur 1 (strichpunktierter Bereich), aus dem die Abscheidung der einzeilnen Sputterlagen (4 nm dick) deutlich werden soll. Dabei sind die einzelnen Titanlagen mit kleinen Buchstaben und die Titannitridlagen mit großen Buchstaben gekennzeichnet. Die Qualität der Titannitridabscheidung (5) kann nach dem Sputtervorgang visuell durch das Auftreten einer braun-violett-metallischen Oberfläche kontrolliert werden. Weitere Möglichkeiten der Kontrolle sind : Messung des Schichtwiderstandes (16,7 Ohm/square), der Schichtdicke und des Schichtgefüges der Titannitridschicht (5) durch REM-Aufnahmen.

Das Schichtgefüge sollte stängelig sein (111-Textur).

In Figur 3 ist mit dem Bezugszeichen 7 die drehbar (siehe Pfeil 8) ausgebildete Palette bezeichnet, auf der acht Scheibenpositionen (11 bis 18) vorhanden sind, die bei jeder Fahrt mit Siliziumkristallscheiben (1, 2, 3) zu bestücken sind. Der Targethalter mit dem Titantarget ist mit dem Bezugszeichen 9 und der als Heizer dienende Infrarotstrahler mit dem Bezugszeichen 10 bezeichnet.

Wie aus der Figur ersichtlich ist, befindet sich Jeweils mindestens eines (11, 15) der acht Substrate (11 bis 18) unter dem Target 9 bzw. unter dem Heizstrahler 10.

Der Sputterprozeß wird beispielsweise so eingestellt, daß bei einer Gesamtschichtdicke von 120 nm bei der reinen Titanbeschichtung 5 Umdrehungen der Palette 7 und bei der Titannitridbeschichtung 25 Umdrehungen der Palette durchgeführt werden. Die Dauer des Aufstäubens beträgt für jeweils acht Scheiben bei der Titanbeschichtung 30 sec und bei der Titannitridbeschichtung 500 sec.

## Ansprüche

1. Verfahren zum Herstellen von als Kontakt- und Barriereschicht wirkenden, aus Titan/Titannitrid bestehenden Doppelschichten (4, 5), wie sie zwischen Metallisierungen (6) auf Aluminiumbasis und Silizium-und/oder Silizid/Polyzid-Oberflächen (2) in höchstintegrierten Halbleiterschaltungen verwendet werden, durch Kathodenzerstäuben (Sputtern) aus einem Titantarget (9) unter Zuschalten von Stickstoff in einer Einkammer-Anlage mit statischem Magnetron, **dadurch gekennzeichnet**, daß sowohl die Titanschicht (4), als auch die Titannitridschicht (5) in mehreren Einzellagen (a bis e, A bis Z) abgeschieden wird wobei zwischen den einzelnen Abscheidungsschritten eine Temperaturbehandlung (10) durchgeführt wird und daß bei der Abscheidung der Titannitridschicht (5) der Stickstoffanteil im Reaktionsgas höher eingestellt wird, als es der Stöchiometrie der Verbindung Titan : Stickstoff in der Titannitridschicht entspricht.

2. Verfahren nach Anspruch 1, **dadurch gekennzeichnet**, daß die Schichtdicke der Einzellagen (a bis e, A bis Z), im Bereich von 3 bis 5 nm, vorzugsweise auf 4 nm, eingestellt wird.

3. Verfahren nach Anspruch 1 und 2, **dadurch gekennzeichnet**, daß die Temperaturbehandlung (10) im Bereich von 250 bis 350°C, vorzugsweise bei 300°C, durchgeführt wird.

4. Verfahren nach einem der Ansprüche 1 bis 3, **dadurch gekennzeichnet**, daß eine DC-Einkammer-Sputteranlage verwendet wird, bei der die für die Beschichtung vorgesehenen Substrate (11 bis 18) auf einer, in der Horizontalen drehbaren (8) Palette (7) ortsfest angeordnet sind, die Palette (7) während der Beschichtung in Umdrehungen (8) versetzt wird und die Drehgeschwindigkeit so eingestellt wird, daß eine Umdrehung der Abscheidung einer Einzellage entspricht.

5. Verfahren nach Anspruch 4, **dadurch gekennzeichnet**, daß die Sputterleistung (9) in einem Bereich von 3 kW eingestellt wird.

6. Verfahren nach einem der Ansprüche 1 bis 5, **dadurch gekennzeichnet**, daß die Beschichtung so lange fortgesetzt wird, bis mindestens vier Lagen Titan, vorzugsweise fünf (a bis e) und mindestens zwanzig Lagen Titannitrid, vorzugsweise fünfundzwanzig (A bis Z) abgeschieden sind.

7. Verfahren nach einem der Ansprüche 1 bis 6, **dadurch gekennzeichnet**, daß als Trägergas Argon verwendet wird und der Anfangsdruck im Reaktionsraum auf mindestens $7 \times 10^{-5}$ pa eingestellt wird.

8. Verfahren nach einem der Ansprüche 1 bis 7, **dadurch gekennzeichnet**, daß der Gasfluß (für Argon) bei der Abscheidung der Titanschicht (4) auf 45 bis 50 cm³/min (sccm) und bei der Abscheidung der Titannitridschicht (5) auf 20 bis 25 cm³/min (sccm) (für Argon) und auf 30 bis 35 sccm für (Stickstoff) eingestellt wird und der Sputterdruck im Reaktionsraum im Bereich von 0.7 pa liegt.

9. Verfahren nach einem der Ansprüche 1 bis 8, **dadurch gekennzeichnet**, daß unmittelbar vor der Beschichtung eine Oberflächenreinigung der Substrate (11 bis 18) in einem fluorwasserstoffhaltigen Medium vorgenommen wird.

## Claims

1. Process for the manufacture of double layers (4, 5) consisting of titanium/titanium nitride and acting as contact and barrier layer, such as are used between aluminium-based metallizations (6) and silicon and/or silicide/polycide surfaces (2) in very large scale integrated semiconductor circuits, by means of cathode sputtering from a titanium target (9), adding nitrogen in a single-chamber installation with static magnetron, characterized in that both the titanium layer (4) and the titanium nitride layer (5) are deposited in several single layers (a to e, A to Z), a temperature treatment (10) being carried out between the individual deposition steps, and in that during the deposition of the titanium layer (5) the nitrogen content in the reaction gas is adjusted to be higher than corresponds to the stoichiometry of the titanium : nitrogen compound in the titanium nitride layer.

2. Process according to Claim 1, characterized in that the layer thickness of the individual layers (a to e, A to Z) is adjusted within a range from 3 to 5 nm, preferably to 4 nm.

3. Process according to Claim 1 and 2, characterized in that the temperature treatment (10) is carried out within a range from 250 to 350°C, preferably at 300°C.

4. Process according to one of Claims 1 to 3, characterized in that a DC single-chamber sputtering installation is used in which the substrates (11 to 18) intended for the coating are arranged fixed in location on a pallet (7) which is rotatable in the horizontal plane (8), the pallet (7) is rotated (8) during the coating and the speed of rotation is adjusted in such a manner that one revolution corresponds to the deposition of a single layer.

5. Process according to Claim 4, characterized in that the sputtering power (9) is adjusted within a range of 3 kW.

6. Process according to one of Claims 1 to 5, characterized in that the coating is continued until at least four layers of titanium, preferably five (a to e) and at least twenty layers of titanium nitride, preferably twenty-five (A to Z) are deposited.

7. Process according to one of Claims 1 to 6, characterized in that argon is used as a carrier gas and the initial pressure in the reaction space is adjusted to at least $7 \times 10^{-5}$ pa.

8. process according to one of Claims 1 to 7, characterized in that the gas flow (for argon) is adjusted to 45 to 50 cm³/min (sccm) in the deposition of the titanium layer (4) and to 20 to 25 cm³/min (sccm) (for argon) and to 30 to 35 sccm (for nitrogen) in the deposition of the titanium nitride layer (5) and the sputtering pressure is within a range of 0.7 pa in the reaction space.

9. Process according to one of Claims 1 to 8, characterized in that a surface cleaning of the substrates (11 to 18) in a medium containing hydrogen fluoride is carried out immediately before the coating.

## Revendications

1. Procédé de fabrication de couches doubles (4, 5) en titane/nitrure de titane servant de couches de contact et de couches d'arrêt, comme on en utilise entre des parties métallisées (6) à base d'aluminium et des surfaces (2) en silicium et/ou en siliciure/polysiliciure, dans des circuits à semiconducteurs à très haut degré d'intégration, par pulvérisation cathodique (sputter) à partir d'une cible de titane, avec admission d'azote dans une installation à chambre unique et à magnétron statique, caractérisé en ce qu'à la fois le revêtement de titane (4) et le revêtement de nitrure de titane (5) sont déposés en plusieurs couches individuelles (a à e, A à Z), un traitement thermique (10) étant effectué entre les divers stades de dépôt, et en ce que le procédé consiste à régler, lors du dépôt du revêtement de nitrure de titane, la proportion d'azote dans le gaz de réaction à une valeur plus élevée que celle qui correspond à la stoechiométrie du composé titane : azote dans le revêtement de nitrure de titane.

2. Procédé suivant la revendication 1, caractérisé en ce qu'il consiste à régler l'épaisseur des couches individuelles (a à e, A à Z) entre 3 et 5 nm et, de préférence, à 4 nm.

3. Procédé suivant la revendication 1 ou 2, caractérisé en ce qu'il consiste à effectuer le traitement thermique (10) entre 250 et 350°C et, de préférence, à 300°C.

4. Procédé suivant l'une des revendications 1 à 3, caractérisé en ce qu'il consiste à utiliser une installation de pulvérisation cathodique à chambre unique et à courant continu, dans laquelle les substrats (11 à 18), prévus pour le dépôt, sont montés fixes sur une palette (7) horizontale et pouvant tourner (8), la palette (7) étant mise en rotation (8) pendant le dépôt et la vitesse de rotation étant réglée de manière qu'une rotation corresponde au dépôt d'une seule couche.

5. Procédé suivant la revendication 4, caractérisé en ce qu'il consiste à régler la puissance de la pulvérisation cathodique (9) à 3 kW environ.

6. Procédé suivant l'une des revendications 1 à 5, caractérisé en ce qu'il consiste à poursuivre le dépôt jusqu'à ce qu'au moins quatre et, de préférence, cinq couches de titane (a à e) et au moins vingt et, de préférence, vingt-cinq couches de nitrure de titane (A à Z) aient été déposées.

7. Procédé suivant l'une des revendications 1 à 6, caractérisé en ce qu'il consiste à utiliser de l'argon comme gaz porteur et à régler la pression initiale dans la chambre de réaction à au moins $7 \times 10^{-5}$ Pa.

8. Procédé suivant l'une des revendications 1 à 7, caractérisé en ce qu'il consiste à régler le débit de gaz (pour l'argon), lors du dépôt du revêtement de titane (4), entre 45 et 50 cm³/minute et, lors du dépôt du revêtement de nitrure de titane (5), entre 20 et 25 cm³/minute (pour l'argon), et entre 30 et 35 cm³/minute (pour l'azote), et à régler la pression de pulvérisation cathodique dans la chambre de réaction aux environs de 0,7 Pa.

9. Procédé suivant l'une des revendications 1 à 8, caractérisé en ce qu'il consiste à effectuer un nettoyage de la surface des substrats (11 à 18) dans un milieu fluorhydrique, immédiatement avant le dépôt.

FIG 1

FIG 2

FIG 3